# EUROPEAN PATENT APPLICATION

(11) **EP 4 546 986 A1**
(43) Date of publication of application: **30.04.2025**
(21) Application number: 23870697.2
(22) Date of filing: 25.09.2023
(51) Int. Cl.: H10K 30/10, H10K 30/50, H10K 30/80, H10K 30/88, H01L 31/0216

(54) **SOLAR CELL**

(30) Priority: 28.09.2022 CN 202222584432 U; 28.09.2022 CN 202211188919
(71) Applicant: Trina Solar Co., Ltd, Changzhou, Jiangsu 213031 (CN)
(72) Inventor: CHEN, Yifeng, hangzhou, Jiangsu 213031 (CN); XIA, Rui, hangzhou, Jiangsu 213031 (CN); MA, Jun, hangzhou, Jiangsu 213031 (CN); GAO, Jifan, hangzhou, Jiangsu 213031 (CN)
(74) Representative: Arnold & Siedsma
(86) International application number: PCT/CN2023/121039
(87) International publication number: WO 2024/067466

(57) **Abstract**

A solar cell, structurally comprising a photoactive layer (2), wherein the photoactive layer (2) is a perovskite photoactive layer, at least one first p-type region (3) and at least one first n-type region (4) are provided at the bottom of the photoactive layer (2), each first n-type region (4) is spaced apart from any first p-type region (3), and electrodes (5) are independently provided below each first p-type region (3) and each first n-type region (4), respectively.

## Description

### RELATED APPLICATIONS

This application claims priority to Chinese patent applications filed on September 28, 2022, with Chinese patent application No. 202222584432.4 entitled "SOLAR CELL" and with Chinese patent application No. 202211188919.9 entitled "SOLAR CELL", which are hereby incorporated herein in their entireties by reference.

### TECHNICAL FIELD

The present application relates to the field of photovoltaics, particularly to a solar cell, and more particularly to a structure of an organic metal halide perovskite solar cell.

### BACKGROUND

Organic metal halide perovskite solar cells have become one of the hot spots in the photovoltaic field due to the characteristics of low cost and high efficiency, and devices of such cells have also received widespread attention in the commercialization process. The perovskite solar cells typically consist of substrates, perovskite layers, electron transport layers, hole transport layers, and external electrodes, where the electron transport layers and the hole transport layers are collectively referred to as charge transport layers. The working principle of the perovskite solar cells is as follows: the perovskite layer absorbs light to generate electron-hole pairs which are quickly separated into electrons and holes in the perovskite layer, and the electrons and the holes are extracted by the electron transport layer and the hole transport layer respectively, and then transported to the external circuit. Currently, in the structures of the perovskite solar cells that have been studied, the perovskite layer is typically sandwiched between the electron transport layer and the hole transport layer, and the electron transport layer or the hole transport layer located on both sides of the perovskite layer will cause certain parasitic absorption, thus affecting the photoresponse of the perovskite layer.

In related art, one technical solution discloses a perovskite solar cell, wherein the structure of the perovskite solar cell with a silicon-based film material includes: a conductive glass, an n-type electron transport layer formed on the conductive glass, a perovskite photosensitive layer formed on the n-type electron transport layer, a p-type hole transport layer formed on the perovskite photosensitive layer, and a metal counter electrode formed on the p-type hole transport layer. The disclosed solar cell structure is a conventional perovskite solar cell structure, the p-type layer and the n-type layer are disposed at both sides of the perovskite photosensitive layer, and the electron transport layer or the hole transport layer on both sides of the perovskite layer will cause certain parasitic absorption, thereby affecting the photoresponse of the perovskite layer.

Another technical solution discloses an orthogonal interdigitated all-back-contact perovskite solar cell and a preparation method thereof. The structure from bottom to top includes: 1) a substrate, 2) a positive electrode, 3) a hole transport layer, 4) an insulation isolation layer, 5) a negative electrode, 6) an electron transport layer, 7) a perovskite absorption layer, 8) a passivation layer, and 9) an anti-reflection protection layer. The anti-reflection layer is disposed on the perovskite absorption layer, and the hole transport layer and the electron transport layer are separated by the negative electrode. Since the hole transport layer and the electron transport layer are separated by the negative electrode, the electrodes are in close contact, and even if they are separated by the insulation isolation layer, a risk of short circuit exists.

A yet another technical solution discloses a parallel interdigitated all-back-contact perovskite solar cell structure. The structure includes in sequence from bottom to top: 1) a substrate, 2) a positive electrode, 3) a negative electrode, 4) a hole transport layer, 5) an electron transport layer, 6) a perovskite absorption layer, 7) a passivation layer, and 8) an anti-reflection protection layer. The anti-reflection layer is disposed on the perovskite absorption layer, and the structure in which the hole transport layer and the electron transport layer are spaced apart is adopted. However, from bottom to top the negative electrode to the electron transport layer are embedded in the perovskite absorption layer, so that the cell structure can only be used in a certain structure, and cannot be stacked or disassembled for use, thus resulting in limitations.

How to prepare a perovskite solar cell with high energy conversion efficiency and adequately improved light absorption of a photoactive layer by a simple preparation method is an important direction for the structure research of perovskite solar cells.

### SUMMARY

According to various embodiments of the present application, a solar cell is provided, and a structure of the solar cell includes a photoactive layer.

The photoactive layer is a perovskite photoactive layer. At least one first p-type region and at least one first n-type region are disposed at a bottom of the photoactive layer, each first n-type region is spaced apart from any first p-type region, and electrodes are independently disposed below each first p-type region and each first n-type region, respectively.

In an embodiment of the present application, the photoactive layer is in contact with each first n-type region to form a heterojunction structure.

In an embodiment of the present application, the photoactive layer is in contact with each first p-type region to form a heterojunction structure.

In an embodiment of the present application, each first p-type region and each first n-type region are each in a rectangular shape, and at least one first p-type region and at least one first n-type region are alternately disposed and spaced apart from each other along an extending direction perpendicular to the rectangular shape.

In an embodiment of the present application, one first n-type region is disposed between adjacent two first p-type regions.

In an embodiment of the present application, a minimum distance between each first n-type region and any first p-type region is approximately greater than 0 cm and less than or equal to 1 cm.

In an embodiment of the present application, each first n-type region includes at least one first n-type layer.

A material of each first n-type layer includes any one or a combination of at least two of n-type monocrystalline silicon, n-type polycrystalline silicon, n-type amorphous silicon, TiO₂, SnO₂, ZnO, ZrO₂, GZO, IZO, FTO, ITO, BaSnO₃, TiSnOₓ, SnZnOₓ, or fullerene and a derivative thereof, where 0<x≤4.

In an embodiment of the present application, a thickness of each first n-type region is less than or equal to about 100 µm.

In an embodiment of the present application, each first p-type region includes at least one first p-type layer.

A material of each first p-type layer includes any one or a combination of at least two of p-type monocrystalline silicon, p-type polycrystalline silicon, p-type amorphous silicon, 2,2',7,7'-tetrakis[N,N-di(4-methoxyphenyl)amino]-9,9'-spirobifluorene, polyethylene terephthalate, a polymer of 3-hexylthiophene, PEDOT:PSS, Spiro-TTB, F4-TCNQ, F6TCNNQ, TAPC, NiOₓ, CuSCN, CuAlO₂, or V₂O₅.

In an embodiment of the present application, a thickness of each first p-type region is less than or equal to about 100 µm.

In an embodiment of the present application, at least one active layer is disposed between each first n-type region and the electrode;
each active layer includes an intermediate layer, a second p-type region, a silicon material layer, and a second n-type region connected sequentially from top to bottom.

In an embodiment of the present application, at least one active layer is disposed between each first n-type region and the electrode;
each active layer includes an intermediate layer, a second n-type region, a silicon material layer, and a second p-type region connected sequentially from top to bottom.

In an embodiment of the present application, at least one active layer is disposed between each first p-type region and the electrode;
each active layer includes an intermediate layer, a second p-type region, a silicon material layer, and a second n-type region connected sequentially from top to bottom.

In an embodiment of the present application, at least one active layer is disposed between each first p-type region and the electrode;
each active layer includes an intermediate layer, a second n-type region, a silicon material layer, and a second p-type region connected sequentially from top to bottom.

In an embodiment of the present application, a material of the intermediate layer includes any one or a combination of at least two of polycrystalline silicon, amorphous silicon, TiO₂, SnO₂, ZnO, ZrO₂, GZO, IZO, FTO, ITO, BaSnO₃, TiSnOₓ, SnZnOₓ, or fullerene and a derivative thereof.

In an embodiment of the present application, a thickness of the intermediate layer is less than or equal to about 100 µm.

In an embodiment of the present application, each second p-type region includes at least one second p-type layer.

A material of each second p-type layer includes any one or a combination of at least two of p-type monocrystalline silicon, p-type polycrystalline silicon, or p-type amorphous silicon.

In an embodiment of the first aspect, each second n-type region includes at least one second n-type layer.

A material of each second n-type layer includes any one or a combination of at least two of n-type monocrystalline silicon, n-type polycrystalline silicon, or n-type amorphous silicon.

In an embodiment of the present application, each second n-type layer and each second p-type layer each have a thickness of less than or equal to about 100 µm.

In an embodiment of the present application, the silicon material layer includes any one or a combination of at least two of n-type polycrystalline silicon, i-type polycrystalline silicon, and p-type polycrystalline silicon.

In an embodiment of the present application, the photoactive layer includes an organic metal halide perovskite material and/or an inorganic metal halide perovskite material.

In an embodiment of the present application, the organic metal halide perovskite material and/or the inorganic metal halide perovskite material include a three-dimensional structure of ABX₃, where A is a monovalent cation, B is a divalent cation, and X is a monovalent anion.

The A includes any one or a combination of at least two of cesium, rubidium, methylamino, or formamidine.

The B includes any one or a combination of at least two of lead, copper, zinc, gallium, tin, or calcium.

The X includes any one or a combination of at least two of iodine, bromine, chlorine, fluorine, or thiocyanate ion.

In an embodiment of the present application, the photoactive layer is a photoactive layer without open porosity.

In an embodiment of the present application, a thickness of the photoactive layer is less than or equal to about 100 µm.

In an embodiment of the present application, an absorption band gap of the photoactive layer is in a range from about 0.9 eV to about 3.0 eV.

In an embodiment of the present application, an anti-reflection layer and a substrate are disposed above the photoactive layer.

In an embodiment of the present application, the substrate includes any one of an FTO conductive glass, an ITO conductive glass, a PI flexible substrate, or a PEN flexible substrate.

In an embodiment of the present application, a material of the anti-reflection layer includes any one or a combination of at least two of LiF, MgF₂, Si₃N₄, SiO₂, or polydimethylsiloxane.

In an embodiment of the present application, a thickness of the anti-reflection layer is less than or equal to about 5 mm.

In an embodiment of the present application, a material of the electrode includes any one or a combination of at least two of Au, Ag, Al, Cu, graphene, or ITO.

In an embodiment of the present application, a thickness of the electrode is less than or equal to about 10 µm.

Details of one or more embodiments of the present application are set forth in the accompanying drawings and description below. Other features, objectives, and advantages of the present application will become apparent from the description, drawings, and claims.

### BRIEF DESCRIPTION OF THE DRAWINGS

To illustrate the technical solutions in the present application or in the conventional art more clearly, the accompanying drawings used in the embodiments or in the conventional art will be described briefly. Apparently, the following described drawings are merely for the embodiments of the present application, and other drawings can be derived by those of ordinary skill in the art without any creative effort.
FIG. 1 is a schematic view showing a position of a substrate in Examples 1 to 7 of the present application.
FIG. 2 is a schematic view of a coating structure on the substrate in Example 1 of the present application.
FIG. 3 is a schematic view of a coating structure on the substrate in Example 2 of the present application.
FIG. 4 is a schematic view of a coating structure on the substrate in Example 3 of the present application.
FIG. 5 is a schematic view of a coating structure on the substrate in Example 4 of the present application.
FIG. 6 is a schematic view of a coating structure on the substrate in Example 5 of the present application.
FIG. 7 is a schematic view of a coating structure on the substrate in Example 6 of the present application.
FIG. 8 is a schematic view of a coating structure on the substrate in Example 7 of the present application.
FIG. 9 is a schematic view of a coating structure in Comparative Example 1 of the present application.
FIG. 10 is a schematic view of a coating structure in Comparative Example 2 of the present application.

### Reference signs:

1: anti-reflection layer; 2: photoactive layer; 3: first p-type region; 4: first n-type region; 5: electrode; 6: intermediate layer; 7: second n-type region; 8: silicon material layer; 9: second p-type region; 10: substrate.

### DETAILED DESCRIPTION

The technical solutions of the embodiments of the present application will be described more clearly and comprehensively below in conjunction with the accompanying drawings for the embodiments of the present application. Apparently, the embodiments described herein are only part of, not all of the embodiments of the present application. Base on the embodiments of the present application, other embodiments obtained by those of ordinary skill in the art without creative efforts shall fall within the protection scope of the present application.

Unless specified otherwise in the context, the term "include" is interpreted as open-ended and inclusive, meaning "include, but is not limited to" throughout the specification and claims. In the description of the specification, terms such as "an embodiment," "some embodiments," "exemplary embodiments," "exemplarily," or "some examples" indicate that specific features, structures, materials, or characteristics related to the embodiments or examples are included in at least one embodiment or example in the present application. The exemplary expressions of the above terms mean that these terms do not necessarily refer to the same embodiment or example. In addition, the specified features, structures, materials, or characteristics can be incorporated in one or multiple embodiments or examples in any appropriate manners.

The exemplary embodiments are described herein with reference to cross-sectional views and/or plan views as idealized exemplary drawings. In the drawings, the thickness of layers and regions is exaggerated for clarity. Therefore, variations in shape upon the drawings may occur due to manufacturing techniques and/or tolerances. Thus, the exemplary embodiments should not be interpreted as limited to the shapes of the regions as shown herein, but include shape variations caused by such as manufacturing. For instance, an etched area shown as a rectangle may typically have curved features. Therefore, the regions shown in the drawings are essentially schematic and not intended to represent the actual shapes of regions of a device, nor are they meant to limit the scope of the exemplary embodiments.

The term "A and/or B" indicates three conditions: only A, only B, and a combination of A and B.

In the present application, unless otherwise specified, "one or more" indicates one, or equal to or greater than two.

Terms such as "for example", "such as", "exemplary", and "for instance" herein are for descriptive purposes, indicating a connection between preceding and following technical solutions in terms of content, but should not be construed as limiting the preceding technical solution or the protection scope of the present application. In the context, unless otherwise specified, A (such as B) means that B is a non-limiting example of A, indicating that A is not limited to B.

In the context, the terms "first" and "second" in "first aspect" and "second aspect" are only used for descriptive purposes and cannot be understood as indicating or implying relative importance or quantity, nor implicitly indicating the importance or quantity of the indicated technical features.

It should be noted that when an element is referred to as "fixed to" or "disposed on" another element, it may be directly disposed on the other element or an intermediate element may exist. When an element is considered to be "connected to" another element, it may be directly connected to the other element or an intermediate element may co-exist. The terms "vertical", "horizontal", "upper", "lower", "left", "right" and similar expressions used herein are only for illustrative purposes and are not intended to represent the only embodiment.

Unless defined otherwise, all technical and scientific terms used herein have the same meaning as commonly understood by those skilled in the art of the present application. The terms used in the specification of the present application are only for the purpose of describing specific examples and are not intended to limit the present application.

In the context, the technical features defined in open-ended description includes a close-ended technical solution consisting of the recited technical features, and also includes an open-ended technical solution including the recited technical features.

In the context, the term "at least one" means one or more than one, such as one, two, and more than two. The terms "more" or "several" means at least two, for example, two, three, etc., unless specifically defined otherwise.

In the context, unless otherwise specified, when a numerical interval (i.e., a numerical range) is referred to, the suitable values are considered as continuously distributed within this numerical interval and include both endpoints of the numerical interval (i.e., the minimum value and the maximum value), as well as every value between the two endpoints. Unless otherwise specified, when a numerical interval is referred to as encompassing only integers within the numerical interval, it includes the integers at both endpoints of the numerical interval, and every integer between the endpoints, being equivalent to directly listing each integer. When multiple numerical ranges are provided to describe a feature or a characteristic, these ranges can be combined. In other words, the numerical ranges disclosed herein are to be construed to include any or all sub-ranges subsumed therein, unless otherwise specified. The "value" in the numerical interval can be any quantitative value, such as a number, a percentage, a ratio, etc. The "numerical interval" can broadly include percentage intervals, ratio intervals, proportion intervals, and other types of numerical interval.

In view of the issues existing in related art, the present application provides a solar cell structure in which the charge transport layers in the conventional perovskite solar cell structure are disposed on the same side of the perovskite layer, and an anti-reflection film can be optionally deposited on the other side of the perovskite layer, which can more adequately improve light absorption of the photoactive layer, thereby increasing the short-circuit current density of the device and thus enhancing the energy conversion efficiency.

The solar cell provided by the present application will be exemplarily described in detail below.

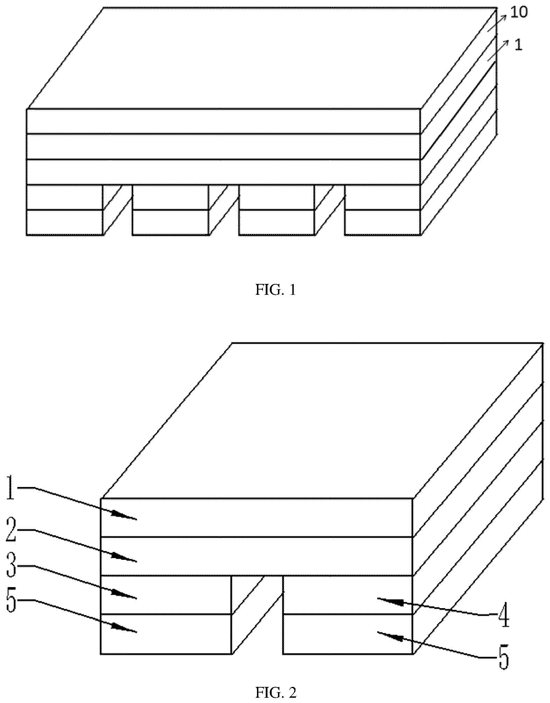

Some embodiments of the present application provide a solar cell. As shown in FIG. 2 to FIG. 8, a structure of the solar cell includes a photoactive layer 2. The photoactive layer 2 is a perovskite photoactive layer.

At least one first p-type region 3 and at least one first n-type region 4 are disposed at the bottom of the photoactive layer 2. Each first n-type region 4 is spaced apart from any first p-type region 3. Electrodes 5 are independently disposed below each first p-type region 3 and each first n-type region 4, respectively.

In the present application, the charge transport layers in the conventional perovskite solar cell structure are disposed on the same side of the perovskite layer, and an anti-reflection layer can be deposited on the other side of the perovskite layer, which can more adequately improve light absorption of the photoactive layer 2, thereby increasing the short-circuit current density of the device and thus enhancing the energy conversion efficiency.

In the present application, the first p-type region 3 can be a hole transport layer, and the first n-type region 4 can be an electron transport layer. The working principle of the solar cell is as follows: after the perovskite layer at the top absorbs light, electrons and holes are respectively extracted by the first n-type region and the first n-type region at the bottom and escape from the film to complete the separation of electron-hole pairs, and then transported to the external circuit through the electrodes.

In some embodiments, the photoactive layer 2 is in contact with each first n-type region 4 to form a heterojunction structure. In these embodiments, the connection between the photoactive layer 2 and each first n-type region 4 is a connection between two different materials, thus forming a heterojunction structure.

In other embodiments, the photoactive layer 2 is in contact with each first p-type region 3 to form a heterojunction structure. In these embodiments, the connection between the photoactive layer 2 and each first p-type region 3 is a connection between two different materials, thus forming a heterojunction structure.

In some embodiments, as shown in FIG. 2 to FIG. 8, each first p-type region 3 and each first n-type region 4 are each in a rectangular shape, and at least one first p-type region 3 and at least one first n-type region 4 are alternately disposed and spaced apart from each other along an extending direction perpendicular to the rectangular shape.

In some embodiments, as shown in FIG. 2 to FIG. 8, one first n-type region 4 is disposed between adjacent two first p-type regions 3.

In some embodiments, a minimum distance between each first n-type region 4 and any first p-type region 3 is approximately greater than 0 cm and less than or equal to 1 cm. The minimum distance can be, for example, 0.5 µm, 1 µm, 10 µm, 100 µm, 1 mm, 3 mm, 6 mm, 9 mm, 1cm, etc., but is not limited to the listed numerical values, and other unlisted numerical values within the numerical range are also applicable.

In some embodiments, each first n-type region 4 includes at least one first n-type layer.

A material of each first n-type layer includes any one or a combination of at least two of n-type monocrystalline silicon, n-type polycrystalline silicon, n-type amorphous silicon, TiO₂, SnO₂, ZnO, ZrO₂, GZO, IZO, FTO, ITO, BaSnO₃, TiSnOₓ, SnZnOₓ, or fullerene and a derivative thereof. Typical but non-limiting examples of such combinations include a combination of the n-type monocrystalline silicon and the n-type polycrystalline silicon, a combination of the n-type amorphous silicon and TiO₂, a combination of SnO₂, ZnO, ZrO₂, and GZO, a combination of IZO, FTO, and ITO, a combination of BaSnO₃, TiSnOₓ, SnZnOₓ, and fullerene and a derivative thereof, or the like, where 0<x≤4. The value of x can be, for example, 1, 2, 3, 4, etc., but is not limited to the listed numerical values, and other unlisted numerical values within the numerical range are also applicable.

In some embodiments, a thickness of each first n-type region 4 is less than or equal to (expressed as "≤") about 100 µm. The thickness can be, for example, 50 nm, 100 nm, 500 nm, 1 µm, 10 µm, 20 µm, 30 µm, 40 µm, 50 µm, 60 µm, 70 µm, 80 µm, 90 µm, 100 µm, etc., but is not limited to the listed numerical values, and other unlisted numerical values within the numerical range are also applicable.

In some embodiments, each first p-type region 3 includes at least one first p-type layer.

A material of each first p-type layer includes any one or a combination of at least two of p-type monocrystalline silicon, p-type polycrystalline silicon, p-type amorphous silicon, 2,2',7,7'-tetrakis[N,N-di(4-methoxyphenyl)amino]-9,9'-spirobifluorene, polyethylene terephthalate, a polymer of 3-hexylthiophene, PEDOT:PSS (poly(3,4-ethylenedioxythiophene):poly(styrene sulfonate)), Spiro-TTB (2,2',7,7'-tetra(N, N-di-tolyl)amino-9,9'-spirobifluorene), F4-TCNQ (2,3,5,6-tetrafluoro-7,7',8,8'-tetracyanoquinodimethane), F6TCNNQ (2,2'-(perfluoronaphthalene-2,6-diylidene)dimalononitrile), TAPC (4,4'-cyclohexylidenebis[N,N-bis(p-tolyl)aniline), NiOₓ, CuSCN, CuAlO₂, or V₂O₅, where x is in a range from 1 to 2, for example, x can be 1 or 2. Typical but non-limiting examples of such combinations include a combination of the p-type monocrystalline silicon and the p-type polycrystalline silicon, a combination of the p-type amorphous silicon and 2,2',7,7'-tetra(N, N-di-tolyl)amino-9,9'-spirobifluorene, a combination of the polyethylene terephthalate, the polymer of 3-hexylthiophene, PEDOT:PSS, and Spiro-TTB, a combination of CuAlO₂ and V₂O₅, or the like.

In some embodiments, a thickness of each first p-type region 3 is less than or equal to (expressed as "≤") about 100 µm. The thickness can be, for example, 50 nm, 100 nm, 500 nm, 1 µm, 10 µm, 20 µm, 30 µm, 40 µm, 50 µm, 60 µm, 70 µm, 80 µm, 90 µm, 100 µm, etc., but is not limited to the listed numerical values, and other unlisted numerical values within the numerical range are also applicable.

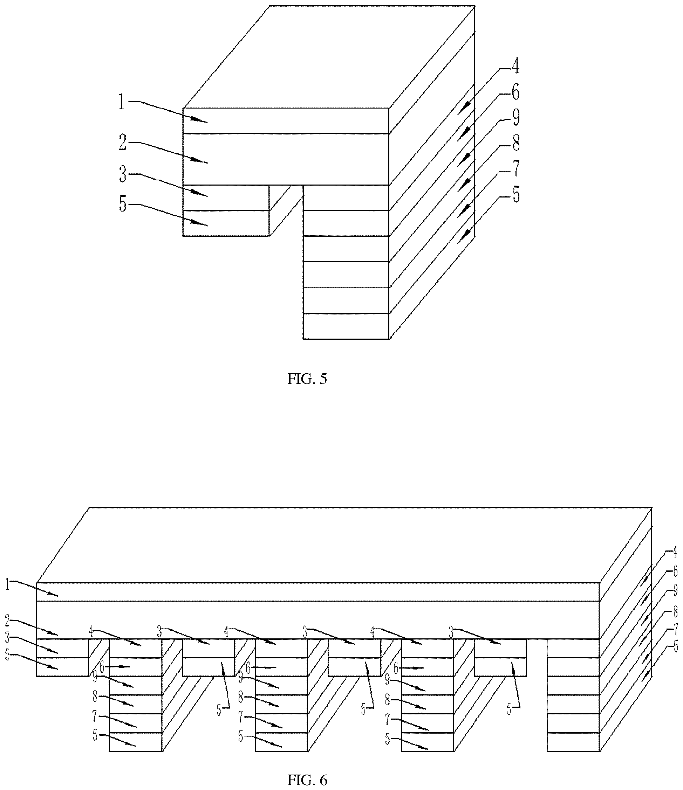

In some embodiments, as shown in FIG. 5 and FIG. 6, at least one active layer is disposed between each first n-type region 4 and the electrode 5. Each active layer includes an intermediate layer 6, a second p-type region 9, a silicon material layer 8, and a second n-type region 7 connected sequentially from top to bottom.

In other embodiments, at least one active layer is disposed between each first n-type region 4 and the electrode 5. Each active layer includes an intermediate layer 6, a second n-type region 7, a silicon material layer 8, and a second p-type region 9 connected sequentially from top to bottom.

In other embodiments, at least one active layer is disposed between each first p-type region 3 and the electrode 5. Each active layer includes an intermediate layer 6, a second p-type region 9, a silicon material layer 8, and a second n-type region 7 connected sequentially from top to bottom.

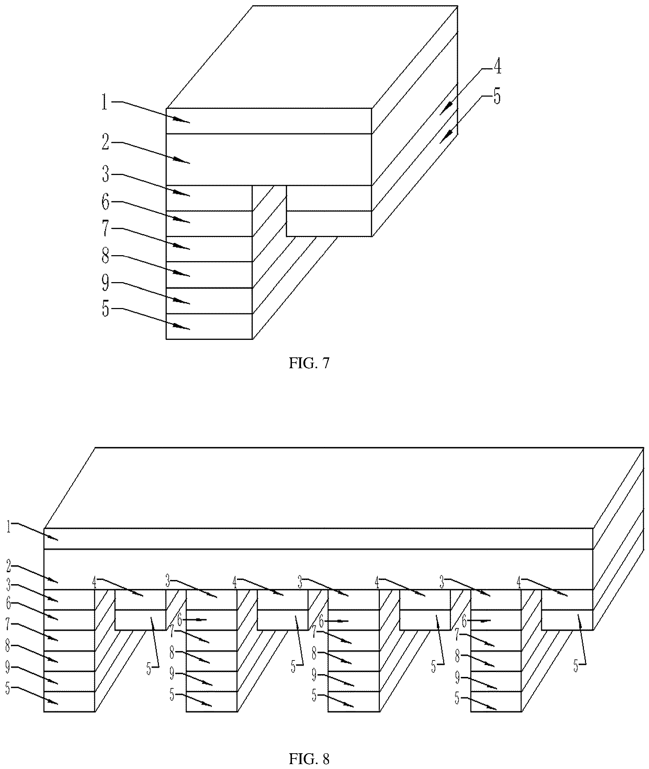

In yet other embodiments, as shown in FIG. 7 and FIG. 8, at least one active layer is disposed between each first p-type region 3 and the electrode 5. Each active layer includes an intermediate layer 6, a second n-type region 7, a silicon material layer 8, and a second p-type region 9 connected sequentially from top to bottom.

In the present application, the active layer is disposed to complete the photoelectric conversion, and can function to absorb the light spectrum in a certain wavelength band alone, or function to distribute the light spectrum by combination with other materials such as the silicon material layer and the perovskite photoactive layer, so as to achieve the purpose of absorbing light in different wavelength bands and improving the efficiency of the cell.

In the present application, the intermediate layer disposed in the active layer has good light transmittance and electrical transmission performances, and can function to connect the upper and lower structures of the cell. The second p-type region functions to extract and conduct holes, the second n-type region functions to extract and conduct electrons, and the silicon material layer functions to absorb light in the long-wavelength band to improve efficiency.

In some embodiments, a material of the intermediate layer 6 includes any one or a combination of at least two of polycrystalline silicon, amorphous silicon, TiO₂, SnO₂, ZnO, ZrO₂, GZO (Gallium Zinc Oxide), IZO (Indium-Zinc-Oxide), FTO (F-doped Tin Oxide), ITO (Indium Tin Oxides), BaSnO₃, TiSnOₓ, SnZnOₓ, or fullerene and a derivative thereof. Typical but non-limiting examples of such combinations include a combination of the polycrystalline silicon and the amorphous silicon, a combination of TiO₂, SnO₂, and ZnO, a combination of ZrO₂, GZO, and IZO, a combination of FTO and ITO, a combination of BaSnO₃, TiSnOₓ, SnZnOₓ, and fullerene and a derivative thereof, or the like.

In some embodiments, a thickness of the intermediate layer 6 is less than or equal to (expressed as "≤") about 100 µm. The thickness can be, for example, 10 nm, 30 nm, 50 nm, 1 µm, 5 µm,10 µm, 20 µm, 30 µm, 40 µm, 50 µm, 60 µm, 70 µm, 80 µm, 90 µm, 100 µm, etc., but is not limited to the listed numerical values, and other unlisted numerical values within the numerical range are also applicable.

In some embodiments, each second p-type region 9 includes at least one second p-type layer.

A material of each second p-type layer includes any one or a combination of at least two of p-type monocrystalline silicon, p-type polycrystalline silicon, or p-type amorphous silicon. Typical but non-limiting examples of such combinations include a combination of the p-type monocrystalline silicon and the p-type polycrystalline silicon, a combination of the p-type polycrystalline silicon and the p-type amorphous silicon, a combination of the p-type monocrystalline silicon and the p-type amorphous silicon, or the like.

In some embodiments, each second n-type region 7 includes at least one second n-type layer.

A material of each second n-type layer includes any one or a combination of at least two of n-type monocrystalline silicon, n-type polycrystalline silicon, or n-type amorphous silicon. Typical but non-limiting examples of such combinations include a combination of the n-type monocrystalline silicon and the n-type polycrystalline silicon, a combination of the n-type polycrystalline silicon and the n-type amorphous silicon, a combination of the n-type monocrystalline silicon and the n-type amorphous silicon, or the like.

In some embodiments, each second n-type layer 7 and each second p-type layer 9 each have a thickness of less than or equal to (expressed as "≤") about 100 µm. The thickness can be, for example, 10 nm, 30 nm, 50 nm, 100 nm, 500 nm, 1 µm, 5 µm, 10 µm, 20 µm, 30 µm, 40 µm, 50 µm, 60 µm, 70 µm, 80 µm, 90 µm, 100 µm, etc., but is not limited to the listed numerical values, and other unlisted numerical values within the numerical range are also applicable.

In some embodiments, the silicon material layer 8 includes any one or a combination of at least two of n-type polycrystalline silicon, i-type polycrystalline silicon, and p-type polycrystalline silicon. Typical but non-limiting examples of such combinations include a combination of the n-type polycrystalline silicon and the i-type polycrystalline silicon, a combination of the i-type polycrystalline silicon and the p-type polycrystalline silicon, a combination of the n-type polycrystalline silicon and the p-type polycrystalline silicon, or the like.

In some embodiments, the photoactive layer 2 includes an organic metal halide perovskite material and/or an inorganic metal halide perovskite material.

In some embodiments, the organic metal halide perovskite material and/or the inorganic metal halide perovskite material include a three-dimensional structure of ABX₃, where A is a monovalent cation, B is a divalent cation, and X is a monovalent anion.

The A includes any one or a combination of at least two of cesium, rubidium, methylamino, and formamidine. Typical but non-limiting examples of such combinations include a combination of cesium and rubidium, a combination of rubidium and methylamino, a combination of methylamino and formamidine, a combination of rubidium, methylamino, and formamidine, or the like. The B includes any one or a combination of at least two of lead, copper, zinc, gallium, tin, and calcium. Typical but non-limiting examples of such combinations include a combination of lead and copper, a combination of copper and zinc, a combination of gallium and tin, a combination of tin and calcium, or the like. The X includes any one or a combination of at least two of iodine, bromine, chlorine, fluorine, and thiocyanate ion. Typical but non-limiting examples of such combinations include a combination of iodine and bromine, a combination of bromine and chlorine, a combination of chlorine, fluorine, and thiocyanate ion, or the like.

In some embodiments, the photoactive layer 2 is a photoactive layer without open porosity. The open porosity refers to a percentage of the volume of pores in a material that can be saturated with water (that is, filled with water) to the volume of the material in a natural state. Herein, the "without open porosity" is specifically used to mean that the photoactive layer 2 does not have pores penetrated by fluids including water and gases.

In some embodiments, a thickness of the photoactive layer 2 is less than or equal to (expressed as "≤") about 100 µm. The thickness can be, for example, 0.3 µm, 0.5 µm, 1 µm, 5 µm, 10 µm, 20 µm, 30 µm, 40 µm, 50 µm, 60 µm, 70 µm, 80 µm, 90 µm, 100 µm, etc., but is not limited to the listed numerical values, and other unlisted numerical values within the numerical range are also applicable.

In some embodiments, an absorption band gap of the photoactive layer 2 is in a range from about 0.9 eV to about 3.0 eV. The band gap can be, for example, 0.9 eV, 1.2 eV, 1.4 eV, 1.5 eV, 1.8 eV, 2.1 eV, 2.4 eV, 2.7 eV, 3.0 eV, etc., but is not limited to the listed numerical values, and other unlisted numerical values within the numerical range are also applicable.

In some embodiments, as shown in FIG. 1, FIG. 2 and FIG. 3, an anti-reflection layer 1 and a substrate 10 are disposed above the photoactive layer 2.

In some embodiments, the substrate 10 includes any one of an FTO conductive glass, an ITO conductive glass, a PI flexible substrate, or a PEN flexible substrate.

In some embodiments, a material of the anti-reflection layer 1 includes any one or a combination of at least two of LiF, MgF₂, Si₃N₄, SiO₂, or polydimethylsiloxane. Typical and non-limiting examples of such combinations include a combination of LiF and MgF₂, a combination of MgF₂ and Si₃N₄, a combination of Si₃N₄ and SiO₂, a combination of SiO₂ and polydimethylsiloxane, or the like.

In some embodiments, a thickness of the anti-reflection layer 1 is less than or equal to (expressed as "≤") about 5 mm. The thickness can be, for example, 1 µm, 5 µm, 10 µm, 1 mm, 2 mm, 3 mm, 4 mm, 5 mm, etc., but is not limited to the listed numerical values, and other unlisted numerical values within the numerical range are also applicable.

In some embodiments, a material of the electrode 5 includes any one or a combination of at least two of Au, Ag, Al, Cu, graphene, or ITO. Typical and non-limiting examples of such combinations include a combination of Au and Ag, a combination of Al and Cu, a combination of graphene and ITO, or the like.

In some embodiments, a thickness of the electrode 5 is less than or equal to (expressed as "≤") about 10 µm. The thickness can be, for example, 50 nm, 100 nm, 500 nm, 1 µm, 2 µm, 3 µm, 4 µm, 5 µm, 6 µm, 7 µm, 8 µm, 9 µm, 10 µm, etc., but is not limited to the listed numerical values, and other unlisted numerical values within the numerical range are also applicable.

In the present application, the methods for preparing all of the above structural layers include any one or a combination of at least two of spin coating, blade coating, evaporation coating, printing, spray coating, spray pyrolysis, slot die coating, mechanical bonding, the chemical vapor deposition method or the physical vapor deposition method. Typical but non-limiting examples of such combinations include a combination of the spin coating and the blade coating, a combination of the evaporation coating and the printing, a combination of the spray coating and the spray pyrolysis, a combination of the slot die coating and the mechanical bonding, or the like. These processes are conventional in the art and are not particularly limited herein.

Compared with the related art, the present application has at least one of the following beneficial effects:
(1) In the present application, the charge transport layers in the conventional perovskite solar cell structure are disposed on the same side of the perovskite layer, and an anti-reflection film is optionally deposited on the other side of the perovskite layer, which can more adequately improve the light absorption of the photoactive layer, thereby increasing the short-circuit current density of the device and thus enhancing the energy conversion efficiency.
(2) Suitable for stacking.
(3) Easy to preparation.

To objectively evaluate the technical effects of the present application, detailed exemplary descriptions will be provided through the following examples and comparative examples. The following descriptions do not limit the protection scope of the present application.

### Example 1

First, a substrate 10 made of FTO glass was taken and disposed on the top of a solar cell. The position of the substrate is shown in FIG. 1.

This example provided a coating structure as shown in FIG. 2, which was disposed on the substrate and was prepared as follows.

The FTO conductive glass with an area of 100×100 cm² was washed, and an MgF₂ layer with a thickness of 1 µm (i.e., anti-reflection layer 1) was prepared on the FTO conductive glass by using the thermal evaporation method.

A MAPbI₃ precursor solution was added dropwise onto the edge of the substrate using a coating machine, and the substrate was completely coated with the solution by using the coating machine at a speed of 1 cm per second. The substrate coated with the MAPbI₃ precursor solution was transferred to a heating table and heated at 100°C for 30 minutes to form a perovskite film with a thickness of 500 nm, i.e., a photoactive layer 2.

A first n-type layer was deposited using a mask. Except for the region where the first n-type layer was to be deposited, the remaining region was shielded using a metal plate. Next, a SnO₂ layer with an area of 49.99×100 cm² and a thickness of 50 nm was deposited on the surface of the photoactive layer 2 by using the chemical vapor deposition method, that is, forming a first n-type region 4.

After completion of deposition, except for the region where the first p-type layer was to be prepared, the remaining region was shielded by a metal plate. A Spiro-TTB layer with a thickness of 150 nm and an area of 49.99×100 cm² was prepared on the surface of the photoactive layer 2 by using the thermal evaporation method, that is, forming a first p-type region 3. The first p-type region and the first n-type region were not in contact, with an interval distance of 1 µm. Finally, the region not for preparing electrodes was shielded by a masking shutter, and Au electrodes with a thickness of 60 nm (i.e., electrodes 5) were prepared on the surfaces of the first p-type region 3 and the first n-type region 4 by the thermal evaporation method.

### Example 2

First, a substrate 10 was taken and disposed on the top of a solar cell. The position of the substrate is shown in FIG. 1.

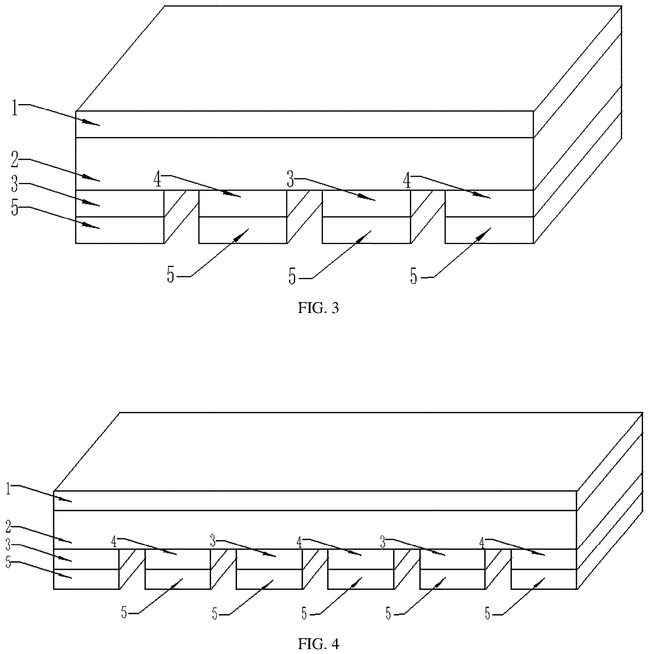

This example provided a coating structure as shown in FIG. 3, which was disposed on the substrate and was prepared as follows.

An ITO conductive glass with an area of 200×100 cm² was washed, and an Si₃N₄ layer with a thickness of 2 mm (i.e., anti-reflection layer 1) was prepared on the ITO conductive glass by using the evaporation coating method.

A Cs_{0.2}FA_{0.8}PbI_{2.4}Br_{0.6} precursor solution was uniformly coated on the ITO conductive glass by using the blade coating method. The substrate coated with the Cs_{0.2}FA_{0.8}PbI_{2.4}Br_{0.6} precursor solution was transferred to a heating table and heated at 100°C for 30 minutes to form a perovskite film with a thickness of 1 µm, i.e., a photoactive layer 2.

A first n-type layer was deposited using a mask. Except for the region where the first n-type layer was to be deposited, the remaining region was shielded using a metal plate. Next, a PCBM layer was prepared on the surface of the photoactive layer 2 by using the slot-die coating method, that is, forming a first n-type region 4 with a thickness of 100 nm and an area of 24.99×100 cm².

After completion of deposition, except for the region where the first p-type layer was to be prepared, the remaining region was shielded by a metal plate. An F4-TCNQ layer was prepared on the surface of the photoactive layer 2 by using the evaporation method, that is, forming a first p-type region 3 with a thickness of 100 nm and an area of 24.99×100 cm². The first n-type region and the first p-type region were not in contact, with an interval distance of 1 µm. Finally, the region not for preparing electrodes was shielded by a masking shutter, and Ag electrodes with a thickness of 80 nm (i.e., electrodes 5) were prepared on the surfaces of the first p-type region 3 and the first n-type region 4 by the spray coating method.

### Example 3

First, a substrate 10 was taken and disposed on the top of a solar cell. The position of the substrate is shown in FIG. 1.

This example provided a coating structure as shown in FIG. 4, which was disposed on the substrate and was prepared as follows.

A PI flexible substrate with an area of 300×100 cm² was washed, and an LiF layer with a thickness of 1 mm (i.e., anti-reflection layer 1) was prepared on the PI flexible substrate by using the spray pyrolysis method.

A CH₃NH₃PbBr₃ precursor solution was uniformly coated on the PI flexible substrate by using the blade coating method. The substrate coated with the CH₃NH₃PbBr₃ precursor solution was transferred to a heating table and heated at 100°C for 30 minutes to form a perovskite film with a thickness of 400 nm, i.e., a photoactive layer 2.

A first n-type layer was deposited using a mask. Except for the region where the first n-type layer was to be deposited, the remaining region was shielded using a metal plate. Next, an IZO layer was prepared on the surface of the photoactive layer 2 by using the evaporation coating method, that is, forming a first n-type region 4 with a thickness of 100 nm and an area of 16×100 cm².

After completion of deposition, except for the region where the first p-type layer was to be prepared, the remaining region was shielded by a metal plate. A CuAlO₂ layer was prepared on the surface of the photoactive layer 2 by using the printing method, that is, forming a first p-type region 3 with a thickness of 150 nm and an area of 16×100 cm². The first p-type region and the first n-type region were not in contact, with an interval distance of 1 µm. Finally, the region not for preparing electrodes was shielded by a masking shutter, and Al electrodes with a thickness of 1 µm (i.e., electrodes 5) were prepared on the surfaces of the first p-type region 3 and the first n-type region 4 by the spray coating method.

### Example 4

First, an FTO substrate 10 was taken and disposed on the top of a solar cell. The position of the substrate is shown in FIG. 1.

This example provided a coating structure as shown in FIG. 5, which was disposed on the substrate and was prepared as follows.

The FTO substrate with an area of 200×100 cm² was washed, and an SiO₂ layer with a thickness of 400 nm (i.e., anti-reflection layer 1) was prepared on the FTO substrate by using the slot die coating method.

An FA_{0.8}MA_{0.2}PbI₃ perovskite film with a thickness of 500 nm (i.e., a photoactive layer 2) was prepared on the FTO substrate by using the thermal evaporation method.

A first n-type layer was deposited using a mask. Except for the region where the first n-type layer was to be deposited, the remaining region was shielded using a metal plate. Next, an SnO₂ layer was prepared on the surface of the photoactive layer 2 by using the coating method, that is, forming a first n-type region 4 with a thickness of 100 nm and an area of 49.99×100 cm².

Next, an ITO layer with a thickness of 40 nm and an area of 49.99×100 cm² (i.e., an intermediate layer 6) was prepared on the first n-type layer by using the sputtering method. A p-type polycrystalline silicon layer was prepared on the ITO layer by using the physical vapor deposition (PVD) method, that is, forming a second p-type region 9 with a thickness of 3 µm and an area of 49.99×100 cm². An n-type silicon material layer was prepared on the p-type polycrystalline silicon layer by using the chemical vapor deposition (CVD) method, that is, forming a silicon material layer 8 with a thickness of 1 µm and an area of 49.99×100 cm². An ITO layer was prepared on the silicon material layer by using the sputtering method, that is, forming a second n-type region 7 with a thickness of 100 nm and an area of 49.99×100 cm².

After completion of the deposition, a CuAlO₂ layer with a thickness of 100 nm and an area of 49.99×100 cm² (i.e., a first p-type region 3) was prepared on the surface of the photoactive layer 2 by using the spray coating method. Finally, the region not for preparing electrodes was shielded by a masking shutter, and Au electrodes with a thickness of 100 nm (i.e., electrodes 5) were prepared on the surfaces of the first p-type region 3 and the first n-type region 4 by using the thermal evaporation method.

### Example 5

First, a substrate 10 was taken and disposed on the top of a solar cell. The position of the substrate is shown in FIG. 1.

This example provided a coating structure as shown in FIG. 6, which was disposed on the substrate and was prepared as follows.

An ITO conductive glass with an area of 400×100 cm² was washed, and an MgF₂ layer with a thickness of 1 µm (i.e., anti-reflection layer 1) was prepared on the ITO substrate by using the thermal evaporation method.

A MAPbI₃ layer with a thickness of 600 nm (i.e., a photoactive layer 2) was prepared on the ITO conductive glass by using the thermal evaporation method.

A first n-type layer was deposited using a mask. Except for the region where the first n-type layer was to be deposited, the remaining region was shielded using a metal plate. Next, a BaSnO₃ layer was prepared on the surface of the photoactive layer 2 by using the slot-die coating method, forming a first n-type region 4 with a thickness of 70 nm and an area of 49.99×100 cm². Next, an IZO layer was prepared on the first n-type layer by using the evaporation coating method, forming an intermediate layer 6 with a thickness of 50 nm and an area of 49.99×100 cm². A p-type polycrystalline silicon layer was prepared on the IZO layer by using the physical vapor deposition (PVD) method, forming a second p-type region 9 with a thickness of 2 µm and an area of 49.99×100 cm². An n-type polycrystalline silicon material layer was prepared on the p-type monocrystalline silicon layer by using the chemical vapor deposition (CVD) method, forming a silicon material layer 8. Then, a second n-type region 7 with a thickness of 1.5 µm and an area of 49.99×100 cm² was formed.

After completion of deposition, except for the region where the first p-type layer was to be prepared, the remaining region was shielded by a metal plate. A PTAA layer was prepared on the surface of the photoactive layer 2 by using the evaporation method, that is, forming the first p-type region 3 with a thickness of 175 nm and a same area of 49.99×100 cm². Finally, the region not for preparing electrodes was shielded by a masking shutter, and Al electrodes with a thickness of 1 µm (i.e., electrodes 5) were prepared on the surfaces of the first p-type region 3 and the first n-type region 4 by the printing method.

### Example 6

This example provided a coating structure as shown in FIG. 7, which was disposed on the substrate. This example was the same as that in Example 1, except that:
An ITO layer with a thickness of 40 nm and an area of 49.99×100 cm² (i.e., an intermediate layer 6) was prepared on the Spiro-TTB layer by using the evaporation coating method. A N-type amorphous silicon layer was prepared on the ITO layer by using the PVD method, i.e., forming a second n-type region 7 with a thickness of 1 µm and an area of 49.99×100 cm². An i-type polycrystalline silicon material layer was prepared on the n-type amorphous silicon layer by using the PVD method, that is, forming a silicon material layer 8 with a thickness of 1 µm and an area of 49.99×100 cm². A p-type polycrystalline silicon layer was prepared on the i-type silicon material layer by using the PVD method, that is, forming a second p-type region 9 with a thickness of 500 nm and an area of 49.99×100 cm².

### Example 7

This example provided a coating structure as shown in FIG. 8, which was disposed on the substrate. This example was the same as that in Example 5, except that:
the TiO₂, the p-type monocrystalline silicon, the silicon material layer, and the n-type monocrystalline silicon were removed from the first n-type layer. A TiSnOₓ layer with a thickness of 150 nm and an area of 49.9×100 cm² (i.e., an intermediate layer 6) was prepared on the V₂O₅ layer by using the printing method. A n-type polycrystalline silicon layer was prepared on the TiSnOₓ layer by using the PVD method, that is, forming a second n-type region 7 with a thickness of 2.5 µm and an area of 49.9×100 cm². Another n-type polycrystalline silicon layer was prepared on the n-type polycrystalline silicon layer by using the printing method, that is, forming a silicon material layer 8 with a thickness of 1 µm and an area of 49.9×100 cm². A p-type amorphous silicon layer was prepared on the silicon material layer by using the CVD method, that is, forming a second p-type region 9 with a thickness of 1.3 µm and an area of 49.9×100 cm².

### Comparative Example 1

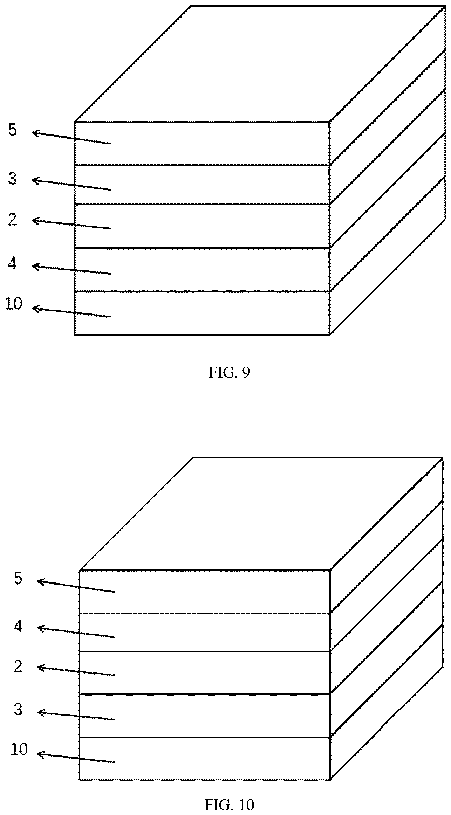

This comparative example provided a coating structure on the substrate as shown in FIG. 9. In this comparative example, a SnO₂ layer (i.e., a first n-type layer 4), an MAPbI₃ perovskite layer (i.e., a photoactive layer 2) and a Spiro-TTB layer (i.e., a first p-type region 3) with the same thickness as those in Example 1, and Au electrodes (i.e., metal electrodes 5) were sequentially prepared on the substrate 10 (i.e., a FTO glass substrate) by using the same method as in Example 1, as shown in FIG. 9.

### Comparative Example 2

This comparative example provided a coating structure on the substrate as shown in FIG. 10. In this comparative example, a F4-TCNQ layer (i.e., a first p-type layer 3), a Cs_{0.2}FA_{0.8}PbI_{2.4}Br_{0.6} perovskite layer (i.e., a photoactive layer 2) and a PCBM layer (i.e., a first n-type region 4) with the same thickness as those in Example 2, and silver electrodes (i.e., metal electrodes 5) were sequentially prepared on the substrate 10 (i.e., an ITO glass substrate) by using the same method as in Example 2, as shown in FIG. 10.

The current density and the energy conversion efficiency of each of the solar cells provided in Examples 1 to 7 and Comparative Examples 1 to 2 were detected. The results are shown in Table 1.

The current density was detected by measuring and integrating the quantum efficiencies of the solar cell under light with different wavelengths.

**Table 1**

| | Current density |
|---|---|
| Example 1 | 24.51 mA/cm² |
| Example 2 | 21.32 mA/cm² |
| Example 3 | 17.44 mA/cm² |
| Example 4 | 20.81 mA/cm² |
| Example 5 | 20.47 mA/cm² |
| Example 6 | 20.22 mA/cm² |
| Example 7 | 20.09 mA/cm² |
| Comparative Example 1 | 22.76 mA/cm² |
| Comparative Example 2 | 18.87 mA/cm² |

The structures provided in the comparative examples are structures of perovskite batteries commonly used currently. From the above results, it can be seen that the present application significantly improves the short-circuit current densities of the devices.

The applicant states that although the detailed structure features of the present application are described through the examples described above, the present application is not limited to the detailed structure features described above, which means that the implementation of the present application does not necessarily depend on the detailed structure features described above. It should be understood by those skilled in the art that any modifications of the present invention, equivalent substitutions of the components used in the present invention, and the addition of the auxiliary components, the selection of the specific means, and the like, are all within the scope of the present application. The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, wherein a structure of the solar cell comprises a photoactive layer,
the photoactive layer is a perovskite photoactive layer,
at least one first p-type region and at least one first n-type region are disposed at a bottom of the photoactive layer, each first n-type region is spaced apart from any first p-type region, and electrodes are independently disposed blow each first p-type region and each first n-type region, respectively.

2. The solar cell according to claim 1, wherein the photoactive layer is in contact with each first n-type region to form a heterojunction structure.

3. The solar cell according to claim 1, wherein the photoactive layer is in contact with each first p-type region to form a heterojunction structure.

4. The solar cell according to any one of claims 1 to 3, wherein each first p-type region and each first n-type region are each in a rectangular shape, and at least one first p-type region and at least one first n-type region are alternately disposed and spaced apart from each other along an extending direction perpendicular to the rectangular shape.

5. The solar cell according to claim 4, wherein one first n-type region is disposed between adjacent two first p-type regions.

6. The solar cell according to any one of claims 1 to 5, wherein a minimum distance between each first n-type region and any first p-type region is approximately greater than 0 cm and less than or equal to 1 cm.

7. The solar cell according to any one of claims 1 to 6, wherein each first n-type region comprises at least one first n-type layer, and
a material of each first n-type layer comprises any one or a combination of at least two of n-type monocrystalline silicon, n-type polycrystalline silicon, n-type amorphous silicon, TiO₂, SnO₂, ZnO, ZrO₂, GZO, IZO, FTO, ITO, BaSnO₃, TiSnOₓ, SnZnOₓ, or fullerene and a derivative thereof, where 0<x≤4.

8. The solar cell according to any one of claims 1 to 7, wherein a thickness of each first n-type region is less than or equal to about 100 µm.

9. The solar cell according to any one of claims 1 to 8, wherein each first p-type region comprises at least one first p-type layer, and
a material of each first p-type layer comprises any one or a combination of at least two of p-type monocrystalline silicon, p-type polycrystalline silicon, p-type amorphous silicon, 2,2',7,7'-tetrakis[N,N-di(4-methoxyphenyl)amino]-9,9'-spirobifluorene, polyethylene terephthalate, a polymer of 3-hexylthiophene, PEDOT:PSS, Spiro-TTB, F4-TCNQ, F6TCNNQ, TAPC, NiOₓ, CuSCN, CuAlO₂, or V₂O₅.

10. The solar cell according to any one of claims 1 to 9, wherein a thickness of each first p-type region is less than or equal to about 100 µm.

11. The solar cell according to any one of claims 1 to 10, wherein at least one active layer is disposed between each first n-type region and the electrode, and each active layer comprises an intermediate layer, a second p-type region, a silicon material layer, and a second n-type region connected sequentially from top to bottom.

12. The solar cell according to any one of claims 1 to 10, wherein at least one active layer is disposed between each first n-type region and the electrode, and each active layer comprises an intermediate layer, a second n-type region, a silicon material layer, and a second p-type region connected sequentially from top to bottom.

13. The solar cell according to any one of claims 1 to 10, wherein at least one active layer is disposed between each first p-type region and the electrode, and each active layer comprises an intermediate layer, a second p-type region, a silicon material layer, and a second n-type region connected sequentially from top to bottom.

14. The solar cell according to any one of claims 1 to 10, wherein at least one active layer is disposed between each first p-type region and the electrode, and each active layer comprises an intermediate layer, a second n-type region, a silicon material layer, and a second p-type region connected sequentially from top to bottom.

15. The solar cell according to any one of claims 11 to 14, wherein a material of the intermediate layer comprises any one or a combination of at least two of polycrystalline silicon, amorphous silicon, TiO₂, SnO₂, ZnO, ZrO₂, GZO, IZO, FTO, ITO, BaSnO₃, TiSnOₓ, SnZnOₓ, or fullerene and a derivative thereof.

16. The solar cell according to any one of claims 11 to 15, wherein a thickness of the intermediate layer is less than or equal to about 100 µm.

17. The solar cell according to any one of claims 11 to 16, wherein each second p-type region comprises at least one second p-type layer, and
a material of each second p-type layer comprises any one or a combination of at least two of p-type monocrystalline silicon, p-type polycrystalline silicon, or p-type amorphous silicon.

18. The solar cell according to any one of claims 11 to 17, wherein each second n-type region comprises at least one second n-type layer, and
a material of each second n-type layer comprises any one or a combination of at least two of n-type monocrystalline silicon, n-type polycrystalline silicon, or n-type amorphous silicon.

19. The solar cell according to claim 18, wherein each second n-type layer and each second p-type layer each have a thickness of less than or equal to about 100 µm.

20. The solar cell according to any one of claims 11 to 19, wherein the silicon material layer comprises any one or a combination of at least two of n-type polycrystalline silicon, i-type polycrystalline silicon, and p-type polycrystalline silicon.

21. The solar cell according to any one of claims 1 to 20, wherein the photoactive layer comprises an organic metal halide perovskite material and/or an inorganic metal halide perovskite material.

22. The solar cell according to claim 21, wherein the organic metal halide perovskite material and/or the inorganic metal halide perovskite material comprise a three-dimensional structure of ABX₃, where A is a monovalent cation, B is a divalent cation, and X is a monovalent anion;
the A comprises any one or a combination of at least two of cesium, rubidium, methylamino, or formamidine,
the B comprises any one or a combination of at least two of lead, copper, zinc, gallium, tin, or calcium,
the X comprises any one or a combination of at least two of iodine, bromine, chlorine, fluorine, or thiocyanate ion.

23. The solar cell according to any one of claims 1 to 22, wherein the photoactive layer is a photoactive layer without open porosity.

24. The solar cell according to any one of claims 1 to 23, wherein a thickness of the photoactive layer is less than or equal to about 100 µm.

25. The solar cell according to any one of claims 1 to 24, wherein an absorption band gap of the photoactive layer is in a range from about 0.9 eV to about 3.0 eV.

26. The solar cell according to any one of claims 1 to 25, wherein an anti-reflection layer and a substrate are disposed above the photoactive layer.

27. The solar cell according to claim 26, wherein the substrate comprises any one of an FTO conductive glass, an ITO conductive glass, a PI flexible substrate, or a PEN flexible substrate.

28. The solar cell according to claim 26 or 27, wherein a material of the anti-reflection layer comprises any one or a combination of at least two of LiF, MgF₂, Si₃N₄, SiO₂, or polydimethylsiloxane.

29. The solar cell according to any one of claims 26 to 28, wherein a thickness of the anti-reflection layer is less than or equal to about 5 mm.

30. The solar cell according to any one of claims 1 to 29, wherein a material of the electrode comprises any one or a combination of at least two of Au, Ag, Al, Cu, graphene, or ITO.

31. The solar cell according to any one of claims 1 to 30, wherein a thickness of the electrode is less than or equal to about 10 µm.
